(19) Europäisches Patentamt
European Patent Office
Office européen des brevets

(11) EP 2 034 513 A1

(12) EUROPEAN PATENT APPLICATION
published in accordance with Art. 153(4) EPC

(43) Date of publication:
11.03.2009 Bulletin 2009/11

(51) Int Cl.:
*H01L 21/027* (2006.01)    *H01L 21/683* (2006.01)

(21) Application number: 07743678.0

(22) Date of filing: 18.05.2007

(86) International application number:
PCT/JP2007/060243

(87) International publication number:
WO 2007/135998 (29.11.2007 Gazette 2007/48)

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK RS

(30) Priority: 24.05.2006 JP 2006143594

(71) Applicant: Nikon Corporation
Tokyo 100-8331 (JP)

(72) Inventor: OKUMURA, Masahiko
Tokyo 100-8331 (JP)

(74) Representative: HOFFMANN EITLE
Patent- und Rechtsanwälte
Arabellastrasse 4
81925 München (DE)

(54) **HOLDING DEVICE AND EXPOSURE DEVICE**

(57) A reticle (R) is supported by flexible reticle holders (72A, 72B) at its +X and -X end portions, and therefore even if there is unevenness on the supported portions of the reticle, the surfaces of the reticle holders are transformed following the unevenness, which makes it possible to restrain deformation of the reticle as much as possible. Further, with support pins (84A to 84C) that contact with the reticle holders at three points that are not in a same straight line, the positions of the reticle holders in a height direction (Z-axis direction) at the contacting portions are set, and in addition, with a self-weight cancelling mechanism that includes piston members (86A to 86C) that contact with the reticle holders at three points that are not in a same straight line, bending due to self weights of the reticle and the reticle holders is restrained.

*Fig. 3*

**Description**

The present invention relates to holding devices and exposure apparatuses, and more particularly, to a holding device that holds a roughly-tabular-shaped object and an exposure apparatus that is equipped with the holding device.

In a lithography process for manufacturing microdevices such as semiconductor devices or liquid crystal display devices, an exposure apparatus is used that transfers a pattern formed on a mask or a reticle (hereinafter generally referred to as a "reticle") onto a photosensitive object such as a wafer or a glass plate (hereinafter generally referred to as a "wafer") which is coated with a resist or the like.

In this type of exposure apparatus, a reticle stage for holding a reticle is arranged. On the reticle stage, a peripheral section of the reticle where patterns to be transferred are not formed is held by a reticle holder.

However, accompanying the recent increase in size of a reticle, the influence on exposure accuracy, which is given by deformation of a reticle and a surface shape of the reticle, or the differences in the deformation and the surface shape among reticles, or the like, also increases. More specifically, in many cases, a reticle holder suctions a reticle by vacuum or the like in a state of supporting the reticle, thereby confining movement of the reticle within a two dimensional plane. In the case when the surface of the reticle to be suctioned is not flat, however, when suctioning the reticle, deformation of the reticle occurs because the surface of the reticle to be suctioned follows the surface shape of the reticle holder. This deformation occurs not only in the case when the reticle is suctioned but also could occur due to the self weight of the reticle. Meanwhile, this deformation causes distortion of a reticle pattern image at the time of exposure, which affects the exposure accuracy.

As a technology to avoid such deformation, a technology "a mask (reticle) table includes at least one flexible member for holding a mask (reticle), and the at least one flexible member follows the shape of the mask (reticle) so as to substantially coincide with the shape" is disclosed Patent Citation 1.

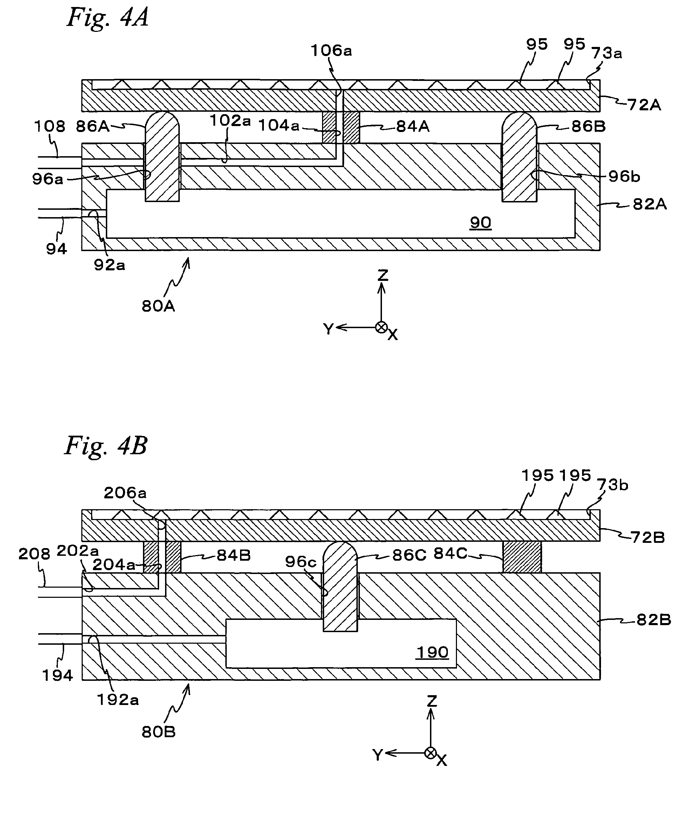

However, in the case when the flexible member as in Patent Citation 1 described above is used (e.g., the case when a configuration as shown in FIG. 4 of the citation is employed), the flexible member itself bends due to the self weights of the flexible member and the reticle. For example, in the case of a scanning exposure apparatus that exposes the reticle by scanning, this bending makes the sectional shape of the reticle different for each position in the scanning direction, and therefore it is very difficult to perform exposure without being affected by the variation in sectional shape for each position in the scanning direction.

Patent Citation 1: Kokai (Japanese Unexamined Patent Application Publication) No. 2001-196303

The present invention has been made under the circumstances described above, and according to a first aspect of the present invention, there is provided a first holding device that holds a roughly-tabular-shaped object, the device comprising: a table; a contacting member arranged on the table; a flexible support member which is arranged on the table in a state where its movement within a horizontal plane is confined, and also a position of which in a height direction at its contacting portion with the contacting member is set by the contacting member that contacts from below, and which supports the object by supporting at least a part of a peripheral section of the object from below; and a self-weight cancelling mechanism that contacts with the support member from below and supports self weights of the object and the support member at its contacting portion.

According to a second aspect of the present invention, there is provided a second holding device that holds a roughly-tabular-shaped object, the device comprising: a table; three first contacting members arranged on the table; a flexible support member which is arranged on the table in a state where its movement within a horizontal plane is confined, and also which is supported by the three first contacting members that contact from below at three first contacting points that are not in a same straight line, a position of which in a height direction at each of the first contacting points is set by the three first contacting members, and which supports the object by supporting at least a part of a peripheral section of the object from below; and m (m is an odd number not less than three) second contacting members that contact with the support member from below at m second contacting points that are not in a same straight line, wherein the three first contacting points and the m second contacting points are arranged in two columns and n rows (n is a natural number not less than three).

According to a third aspect of the present invention, there is provided a first exposure apparatus that transfers a pattern formed on a mask onto a substrate, the apparatus comprising: either the first or second holding device of the present invention that supports the mask as the object.

According to a fourth aspect of the present invention, there is provided a second exposure apparatus that transfers a pattern formed on a mask onto a substrate, the apparatus comprising: either the first or second holding device of the present invention that supports the mask as the object, and comprises a support member supported by contacting points arranged in two columns and n rows (n is a natural number not less than three); and a synchronous movement device that synchronously moves the mask and the substrate in a direction parallel to the columns.

FIG. 1 is a schematic view showing an exposure apparatus related to an embodiment.
FIG. 2 is a plan view showing a reticle stage device including a reticle stage shown in FIG. 1.

FIG. 3 is a perspective view showing a reticle fine movement stage that is extracted.

FIG. 4A is a sectional view of a reticle holder 72A and a support mechanism 80A, and FIG. 4B is a sectional view showing a reticle holder 72B and a support mechanism 80B.

FIG. 5 is a view used to explain deformation caused by the self weight of a reticle in the case when the reticle is supported at three points.

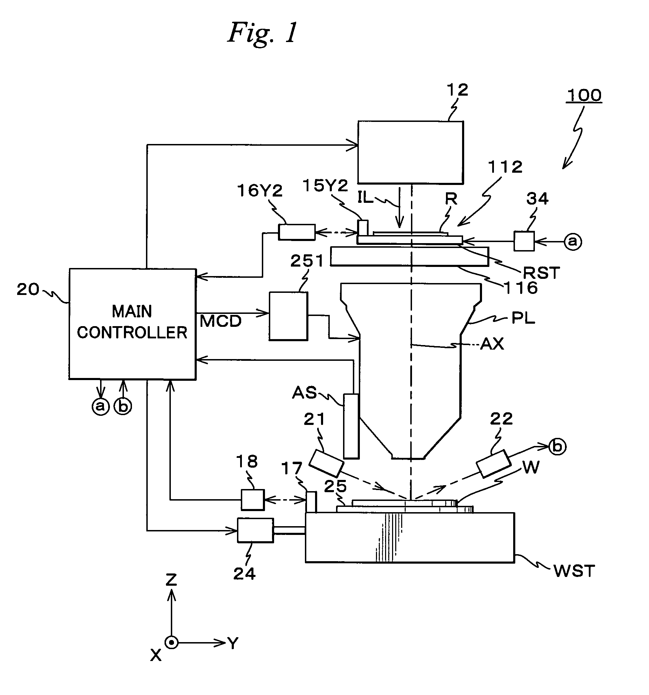

An embodiment of the present invention is described below, referring to FIGS. 1 to 5.

FIG. 1 schematically shows an entire configuration of an exposure apparatus 100 of the embodiment of the present invention. Exposure apparatus 100 is a projection exposure apparatus by a step-and-scan method. As is described later, a projection optical system PL is arranged in the embodiment, and in the following description, it is assumed that a direction parallel to an optical axis AX of projection optical system PL is a Z-axis direction, a scanning direction (a direction parallel to the page surface of FIG. 1) in which a reticle R and a wafer W are relatively scanned within a plane orthogonal to the Z-axis direction is a Y-axis direction, a non-scanning direction (a direction orthogonal to the page surface of FIG. 1) that is orthogonal to this Y-axis is an X-axis direction, and rotation (inclination) directions around the X-axis, the Y-axis and the Z-axis are $\theta x$, $\theta y$ and $\theta z$ directions, respectively.

Exposure apparatus 100 is equipped with an illumination system 12 including a light source and an illumination optical system, a reticle stage device 112 that drives reticle R in the Y-axis direction in a predetermined stroke and also finely drives reticle R in the X-axis direction, the Y-axis direction and the $\theta z$ direction, projection optical system PL, a wafer stage WST on which wafer W is mounted, an alignment detection system AS by an off-axis method, a main controller 20 composed of a computer such as a workstation that performs overall control of the entire apparatus, and the like.

Illumination system 12 is configured including a light source, an illuminance uniformity optical system including an optical integrator and the like, a beam splitter, a relay lens, a variable ND filter, a reticle blind and the like (none of which are shown), as is disclosed in, for example, Kokai (Japanese Unexamined Patent Application Publication) No. 2001-313250 (the corresponding U.S. Patent Application Publication No. 2003/0025890) and the like. Illumination system 12 illuminates a slit-shaped illumination area that is defined by the reticle blind and is elongated in the X-axis direction on reticle R with an illumination light (exposure light) IL with substantially uniform illuminance. In this case, as illumination light IL, an ArF excimer laser light (wavelength: 193nm) is used as an example. Further, as the optical integrator, a fly-eye lens, a rod integrator (an internal reflection type integrator), a diffraction optical element or the like can be used.

A reticle stage platform 116 is horizontally placed below illumination system 12 with a predetermined distance between them, and reticle stage device 112 is placed above (on the +Z side of) reticle stage platform 116.

Reticle stage platform 116 is supported roughly horizontally by, for example, four legs (not shown) on a floor surface. Reticle stage platform 116 is composed of a roughly-plate-shaped member and has a rectangular opening, whose longitudinal direction is in the X-axis direction and which serves as a path of illumination light IL, formed in substantially its center penetrating in the Z-axis direction. The upper surface of reticle stage platform 116 serves as a movement plane of reticle stage RST.

Reticle stage RST is supported by levitation above the upper surface (movement plane) of reticle stage platform 116 via a clearance of, for example, around several $\mu$m. On reticle stage RST, reticle R is fixed by vacuum suction. Reticle stage RST is finely drivable two dimensionally (in the X-axis direction, the Y-axis direction and the $\theta z$ direction) within the XY plane that is perpendicular to optical axis AX of projection optical system PL, and also drivable at a designated scanning speed in the Y-axis direction on reticle stage platform 116, by a reticle stage drive system 34 shown in FIG. 1. Incidentally, a detailed configuration of reticle stage device 112 and the like are described later on.

Projection optical system PL is placed below reticle stage RST in FIG. 1. As projection optical system PL, for example, a dioptric system that is composed of a plurality of lens elements (not shown) that are disposed along optical axis AX parallel to the Z-axis direction is used. Further, projection optical system PL is, for example, both-side telecentric and has a predetermined projection magnification $\beta$ ($\beta$ is, for example, 1/4, 1/5 or 1/8 times, or the like). Therefore, when the illumination area is illuminated with illumination light IL from illumination system 12, illumination light IL having passed through reticle R whose pattern surface is placed substantially coincident with a first plane (an object plane) of projection optical system PL forms a reduced image of a circuit pattern (a reduced image of a part of a circuit pattern) of reticle R within the illumination area, on an exposure area that is conjugate with the illumination area described above on wafer W, which is placed on the second plane (an image plane) side of projection optical system PL and whose surface is coated with a resist (a photosensitive agent), via projection optical system PL. Then, by moving the reticle in the scanning direction (the Y-axis direction) relative to the illumination area (illumination light IL) and also moving wafer W in the scanning direction (the Y-axis direction) relative to the exposure area by synchronous drive of reticle stage RST and wafer stage WST, scanning exposure of one shot area (divided area) on wafer W is performed, and a pattern of the reticle is transferred to the shot area.

Incidentally, in the embodiment, specific lens elements (e.g., predetermined five lens elements) of the plurality of lens elements are drivable independently from each other. Such drive of the specific lens elements is performed by three drive elements such as piezo elements arranged for each of the specific lens elements. More specifically, by individually driving these drive elements, the specific lens elements can be translated independently from each other along optical axis AX in accordance with a displacement amount of each drive element, or a desired inclination with respect to a plane perpendicular to optical axis AX can be given to the specific lens elements. In the embodiment, a drive instructing signal for driving the drive elements described above is output by an image-forming characteristic correction controller 251 based on a command MCD from main controller 20, and a displacement amount of each drive element is controlled by the drive instruction signal.

In projection optical system PL having the configuration as described above, by control of movement of the lens elements with main controller 20 via image-forming characteristic correction controller 251, various aberrations (a kind of optical characteristics) such as distortion, field curvature, astigmatism, comma, or spherical aberration can be adjusted.

Wafer stage WST is placed on a base (not shown) under projection optical system PL in FIG. 1, and a wafer holder 25 is mounted on the upper surface of wafer stage WST. On wafer holder 25, wafer W is fixed by, for example, vacuum suction or the like.

Wafer stage WST is driven in the scanning direction (Y-axis direction) and the non-scanning direction (X-axis direction) by a wafer stage drive system 24 including a motor or the like.

The position of wafer stage WST is constantly detected at a resolution of, for example, around 0.5 to 1nm with a wafer laser interferometer (hereinafter, referred to as a "wafer interferometer") 18 via a movable mirror 17. Positional information (or velocity information) of wafer stage WST is sent to main controller 20. Main controller 20 performs drive control of wafer stage WST based on the positional information (or velocity information) via wafer stage drive system 24.

In addition, wafer stage WST is finely driven also in the Z-axis direction, the θx direction (pitching direction), the θy direction (rolling direction), and the θz direction (yawing direction), by wafer stage drive system 24.

Alignment detection system AS is placed on the side surface of projection optical system PL. In the embodiment, an alignment sensor by an image-forming method that observes marks for position detection (fine alignment marks) formed on wafer W is used as alignment detection system AS. A detailed configuration of alignment detection system AS is disclosed in, for example, Kokai (Japanese Unexamined Patent Application Publication) No. 09-219354. The observation results obtained by alignment detection system AS are supplied to main controller 20.

Further, in the apparatus shown in FIG. 1, a multipoint focus position detection system (21, 22) is arranged, which is a type of a focus detection system (focal detection system) by an oblique incident method used to detect the position of the wafer W surface within the exposure area and an area near the exposure area in the Z-axis direction (optical axis AX direction). A detailed configuration and the like of this multipoint focus position detection system (21, 22) are disclosed in, for example, Kokai (Japanese Unexamined Patent Application Publication) No. 06-283403 (the corresponding U.S. Patent No. 5,448,332) and the like. The detection results obtained by the multipoint focus position detection system (21, 22) are supplied to main controller 20.

Furthermore, in exposure apparatus 100 of the embodiment, although omitted in the drawing, a pair of reticle alignment systems are arranged above reticle R, which are each composed of a TTR (Through The Reticle) alignment optical system using an exposure wavelength used to simultaneously observe reticle marks on reticle R and marks on a fiducial mark plate via projection optical system PL. As these reticle alignment systems, the one having a configuration similar to a configuration disclosed in, for example, Kokai (Japanese Unexamined Patent Application Publication) No. 07-176468 (the corresponding U.S. Patent No. 5,646, 413) and the like.

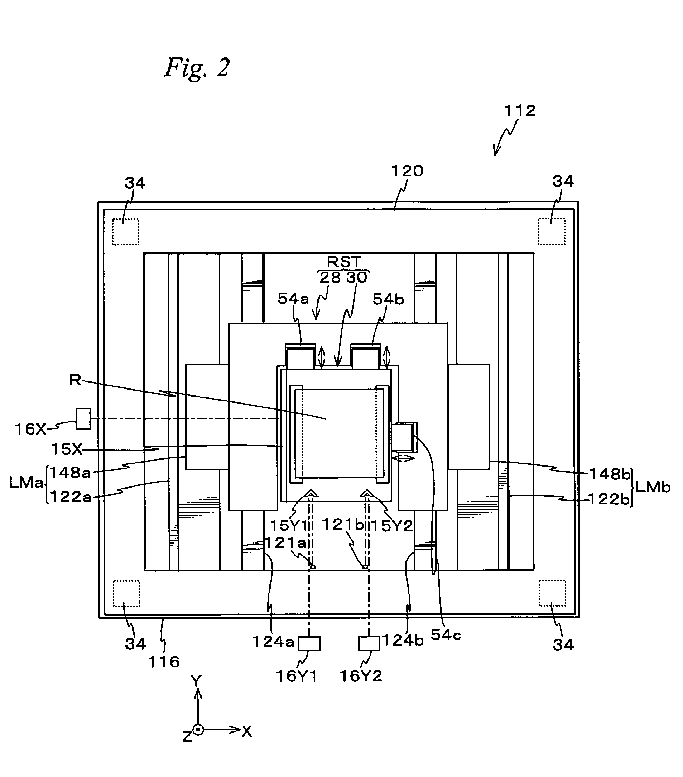

Next, reticle stage device 112 is described in detail. FIG. 2 shows reticle stage device 112 in a plan view.

As shown in FIG. 2, reticle stage device 112 is equipped with reticle stage RST placed above (on the +Z side of) reticle stage platform 116, a counter mass 120 placed above reticle stage platform 116 in a state of enclosing reticle stage RST, the reticle stage drive system that drives reticle stage RST, and the like.

As can be seen from FIG. 2, counter mass 120 has a rectangular frame shape in a planar view, and is supported by static pressure gas bearings 34 of a differential evacuation type, which are arranged in the vicinity of four corners on the lower surface (the surface on the -Z side), in a noncontact manner with the upper surface of reticle stage platform 116. Therefore, this counter mass 120 performs free motion by an action of a force in a horizontal direction.

Incidentally, a trim motor for adjusting the attitude of counter mass 120 can also be arranged.

In a space (within the frame) on the inner side of counter mass 120, Y-axis stators 122a and 122b extending in the Y-axis direction are respectively placed in the vicinity of a -X side end portion and a +X side end portion, and Y-axis guides 124a 124b extending in the Y-axis direction are respectively placed on the inner side of Y-axis stators 122a an 122b. An end portion on the +Y side of each of Y-axis stators 122a and 122b and Y-axis guides 124a and 124b is fixed to the inner wall surface of a side of counter mass 120 on the +Y side, and an end portion on the -Y side of each of them is fixed to the inner wall surface of a side of counter mass 120 on the -Y side.

More specifically, Y-axis stators 122a and 122b and Y-axis guides 124a and 124b are installed between the side on the +Y side and the side on the -Y side of counter mass 120. In this case, Y-axis stators 122a and 122b, and Y-axis guides 124a and 124b are respectively placed symmetrically with respect to a straight line in the Y-axis direction that passes through the center of counter mass 120 in FIG. 2 in a planar view.

Each of Y-axis stators 122a and 122b has a T shape in an XZ section, and is composed of an armature unit having a plurality of armature coils placed in a predetermined pitch along the Y-axis direction.

Each of Y-axis guides 124a and 124b has a rectangular shape in an XZ section, and the flatness of the four surfaces (the upper surface, the lower surface, the right-side surface, and the left-side surface) on the periphery are set high.

As shown in FIG. 2, reticle stage RST is equipped with a reticle coarse movement stage 28 that moves along Y-axis guides 124a and 124b, and a reticle fine movement stage 30 that is finely drivable by three actuators (such as voice coil motors) 54a, 54b and 54c in the X-axis direction, the Y-axis direction and the θz direction with respect to reticle coarse movement stage 28.

To describe these stages in more detail, reticle coarse movement stage 28 has an inverted U shape in a planar view (viewed from above), and at its both end portions of the U shape (portions having a longitudinal direction in the Y-axis direction), an opening having a rectangular shape in an XZ section and penetrating in the Y-axis direction is respectively formed although the openings are not shown, and Y-axis guides 124a and 124b are severally inserted inside these openings. On the inner surfaces (four surfaces) of each of the both end portions of the U shape, a plurality of static pressure gas bearings of a differential evacuation type are arranged, and a distance between Y-axis guides 124a and 124b and reticle coarse movement stage 28 in the Z-axis direction and in the X-axis direction can be maintained at around several $\mu$m by these plurality of static pressure gas bearings of a differential evacuation type. Further, on the -X side end surface and the +X side end surface of reticle coarse movement stage 28, Y-axis movers 148a and 148b each made up of a magnetic pole unit are arranged.

As shown in FIG. 2, Y-axis movers 148a and 148b are respectively engaged with a pair of Y-axis stators 122a and 122b described previously, and Y-axis movers 148a and 148b and Y-axis stators 122a and 122b constitute a pair of Y-axis linear motors LMa and LMb each composed of an electromagnetic power driven linear motor of a moving magnet type that drive reticle stage RST in the Y-axis direction. Incidentally, as Y-axis linear motors LMa and LMb, linear motors of a moving coil type can alternatively used.

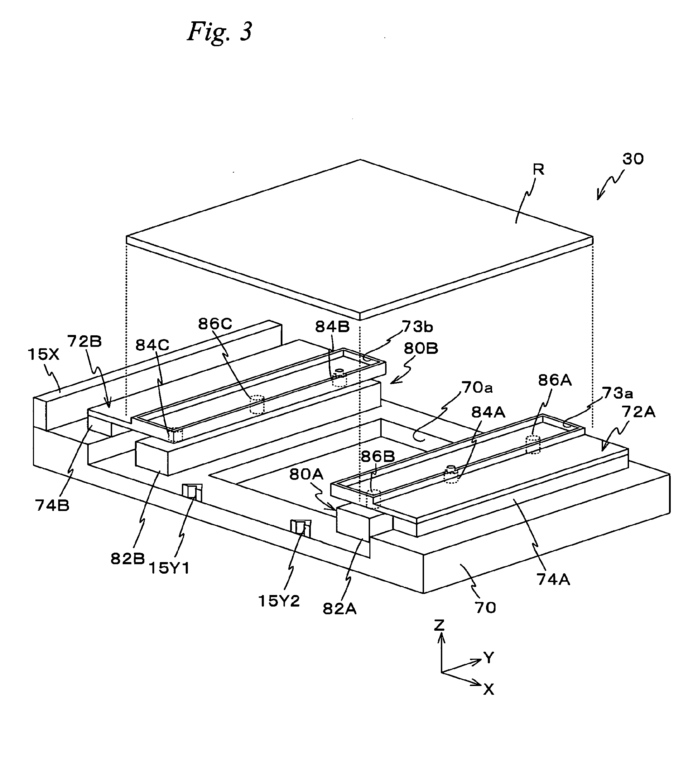

FIG. 3 shows reticle fine movement stage 30 that is extracted in a perspective view. As can be seen from FIGS. 2 and 3, reticle fine movement stage 30 is equipped with a stage main body 70 composed of a roughly-tabular-shaped member having a roughly U shape in an XZ section, and reticle holders 72A and 72B having a longitudinal direction in the Y-axis direction that are arranged above a +X end portion and a -X end portion of stage main body 70, respectively.

In a center portion of stage main body 70, a rectangular opening section 70a is formed as shown in FIG. 3.

One of the reticle holders, reticle holder 72A is composed of, for example, a flexible member such as silica, $CaF_2$, $MgF_2$, $BaF_2$, $Al_2O_3$, or Zerodur (the brand name of Schott AG) and has a roughly tabular shape that is rectangular in a planar view (viewed from above) with its longitudinal direction in the Y-axis direction. The thickness (dimension in the Z-axis direction) of a -X side half section of reticle holder 72A is set thick, and in an area on the -X side half section, a recessed section 73a having a predetermined depth is formed. Recessed section 73a has a rectangular shape in a planar view (viewed from above) with its longitudinal direction in the Y-axis direction, and inside recessed section 73a, a plurality of protruding sections 95 are arranged, as shown in FIG. 4A.

Reticle holder 72A is cantilevered via a block-like member 74A with its longitudinal direction in the Y-axis direction, on stage main body 70. In this case, reticle holder 72A and member 74A can be firmly fixed by a binding material or the like, or for example, a vacuum suction mechanism is arranged on the upper surface of member 74A and reticle holder 72A and member 74A can be fixed by vacuum suction by the vacuum suction mechanism.

On the lower side (-Z side) of reticle holder 72A, a support mechanism 80A is arranged. As can be seen from the drawings such as FIG. 4A that shows a sectional view of support mechanism 80A and reticle holder 72A, support mechanism 80A is equipped with a support mechanism main body 82A having a rectangular parallelepiped shape whose inside is hollow, a support pin 84A arranged in a center portion in the Y-axis direction on the upper surface of support mechanism main body 82A, and piston members 86A and 86B each having a roughly columnar shape (the upper end portion is spherically finished) that are respectively arranged at positions spaced a predetermined distance away from support pint 84A on the +Y side and the -Y side. In this case, piston member 86A, support pin 84A, and piston member 86B are placed at regular intervals in the Y-axis direction.

The hollow section inside support mechanism main body 82A serves as an air chamber 90. One end of a ventilation duct line 92a formed in support mechanism main body 82A communicates with air chamber 90, and to the other end of ventilation duct line 92a, one end portion of an air supply duct 94 is connected from outside. To the other end portion of air supply duct 94, an air supply device (not shown) is connected. This air supply device is configured including, for example, a pump, an air supply valve and the like. Operations of the respective components such as the pump and the air supply valve are controlled by main controller 20 shown in FIG. 1.

Further, in support mechanism main body 82A, through-holes 96a and 96b each having a circular XY section are formed along a vertical direction (the Z-axis direction), and piston members 86A and 86B described previously are inserted so as to be freely slidable in through-holes 96a and 96b.

Furthermore, in support mechanism main body 82A, an exhaust duct line 102a having a roughly L shape is formed so as not to mechanically interfere with through-hole 96a. Exhaust duct line 102a is in a state of communicating with recessed section 73a via a duct line 104a that is formed in a state of penetrating into support pin 84A in the Z-axis direction and a duct line 106a that is formed in a state of penetrating into reticle holder 72A in the Z-axis direction. One end portion of an exhaust duct 108 is connected to the other end of exhaust duct line 102a, and the other end portion of exhaust duct 108 is connected to a vacuum pump (not shown). An operation of this vacuum pump is controlled by main controller 20 shown in FIG. 1.

Referring back to FIG. 3, the other of the reticle holders, reticle holder 72B has substantially the similar configuration to that of reticle holder 72A, though they are bilaterally symmetric. More specifically, reticle holder 72B is also composed of, for example, a flexible member such as silica, $CaF_2$, $MgF_2$, $BaF_2$, $Al_2O_3$, or Zerodur, and has a roughly tabular shape that is rectangular in a planar view (viewed from above) with its longitudinal direction in the Y-axis direction. The thickness (dimension in the Z-axis direction) of a +X side half section of reticle holder 72B is set thick, and in an area on the +X side half section, a recessed section 73b having a predetermined depth is formed. Recessed section 73b has a rectangular shape in a planar view (viewed from above) with its longitudinal direction in the Y-axis direction, and inside recessed section 73b, a plurality of protruding sections 195 are arranged, as shown in FIG. 4B.

Reticle holder 72B is cantilevered via a block-like member 74B with its longitudinal direction in the Y-axis direction, on stage main body 70. In this case as well, reticle holder 72B and member 74B can be firmly fixed by a binding material or the like, or for example, a vacuum suction mechanism is arranged on the upper surface of member 74B and reticle holder 72B and member 74B can be fixed by vacuum suction by the vacuum suction mechanism.

On the lower side (-Z side) of reticle holder 72B, a support mechanism 80B is arranged. As can be seen from the drawings such as FIG. 4B that shows a sectional view of support mechanism 80B and reticle holder 72B, support mechanism 80B is equipped with a support mechanism main body 82B having a rectangular parallelepiped shape in which a hollow section is formed, a piston member 86C having a roughly columnar shape (the upper end portion is spherically finished) that is arranged in a center portion of support mechanism main body 82B in the Y-axis direction, and support pins 84B and 84C that are respectively arranged at positions spaced a predetermined distance away from piston member 86C on the +Y side and the -Y side. Support pin 84B, piston member 86C, and support pin 84D are placed at regular intervals in the Y-axis direction. These intervals are the same as the intervals between the support pin and the piston members of support mechanism 80A shown in FIG. 4A described previously, and the Y-positions of piston member 86A and support pin 84B, the Y-positions of support pin 84A and piston member 86C, and the Y-positions of piston member 86B and support pin 84C are the same positions, respectively.

A hollow section inside support mechanism main body 82B serves as an air chamber 190. The inner volume of air chamber 190 is to be a half of the inner volume of air chamber 90 arranged in support mechanism main body 82A shown in FIG. 4A. One end of a ventilation duct line 192a formed in support mechanism main body 82B communicates with air chamber 190, and to the other end of ventilation duct line 192a, one end portion of an air supply duct 194 is connected from outside. To the other end portion of air supply duct 194, an air supply device (not shown) is connected. This air supply device is configured including, for example, a pump, an air supply valve and the like, and operations of these components are controlled by main controller 20 shown in FIG. 1. Further, in support mechanism main body 82B, a through-hole 96c having a circular XY section is formed along a vertical direction (the Z-axis direction), and a piston member 86C described previously is inserted freely slidable in through-hole 96c.

Furthermore, in support mechanism main body 82B, an exhaust duct line 202a having an L shape is formed. One end of exhaust duct line 202a communicates with recessed section 73b via a duct line 204a formed in a state of penetrating into support pin 84A described previously in the Z-axis direction and a duct line 206a formed in a state of penetrating into reticle holder 72B in the Z-axis direction. One end portion of an exhaust duct 208 is connected to the other end of exhaust duct line 202a, and the other end portion of exhaust duct 208 is connected to a vacuum pump (not shown). An operation of this vacuum pump is controlled by main controller 20 shown in FIG. 1.

With reticle holders 72A and 72B and support mechanisms 80A and 80B that are configured as described above, when reticle R is mounted on reticle holders 72A and 72B and the vacuum pumps (not shown) are operated under instructions of main controller 20, the pressure is reduced inside a space formed by reticle R and recessed section 73a of reticle holder 72A and a space formed between reticle R and recessed section 73b of reticle holder 72B, and reticle R is suctioned by vacuum. In this case, since reticle holders 72A and 72B are configured with flexible members as is described previously, the upper surfaces of reticle holders 72A and 72B are transformed following the shape of the lower surface of reticle R. In other words, the shape of the upper surfaces of reticle holders 72A and 72B are configured to be transformed so as to substantially coincide with the shape of the lower surface (the surface to be held) of reticle R. Accordingly, deformation of reticle R due to vacuum suction of reticle R can be restrained.

Further, reticle holders 72A and 72B are supported from the lower side by support pins 84A to 84C of support mechanisms 80A and 80B. Accordingly, reticle holders 72A and 72B are supported at three points by support pins 84A to 84C and the position of reticle holder 72A or 72B in the Z-axis direction at each support point is confined, and therefore, the position of reticle R in the Z-axis direction is set by the three points.

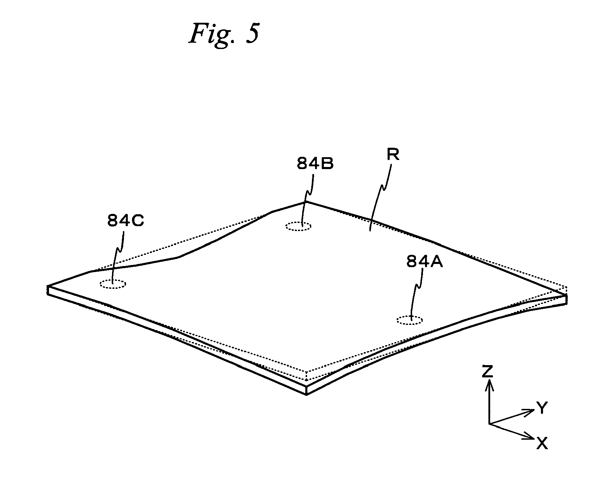

In the embodiment, piston members 86A to 86C are in a state of contacting with reticle holders 72A and 72B, but in the case when such configuration is not employed and reticle holders 72A and 72B are supported only by support pins 84A to 84C, it can be predicted that a section that is not supported by support pins 84A to 84C bends (which is shown in a solid line in FIG. 5) due to the self weights of reticle R and reticle holders 72A and 72B. Occurrence of this bending causes the XZ section of reticle R to vary at each Y-position.

In the case when the XZ section of reticle R varies at each Y-position as is described above, a best image-forming plane of a pattern image of reticle R also varies due to the variation in the XZ section of reticle R at each Y-position, which causes the best focus position and distortion of the pattern image to be different according to the Y-position, in exposure apparatus 100 that performs exposure while moving reticle R in the Y-axis direction as in the embodiment. Although the focus position of wafer W (the position of wafer W in the optical axis AX direction) can be adjusted according to the Y-position of reticle R, it is difficult to perform adjustment of aberrations such as distortion in accordance with the Y-position of reticle R. Consequently, distortion (shape error) of the pattern image occurs according to the Y-position of reticle R.

In the meantime, in the embodiment, by arranging piston members 86A to 86C and air chambers 90 and 190 in support mechanisms 80A and 80B as is described previously, the bending of reticle R as described above is prevented from occurring and Y-position dependency of deformation of reticle R is excluded.

More specifically, with the pressure of a gas inside air chambers 90A and 190A acting on piston members 86A to 86C, an effect as a very weak spring is produced. More specifically, piston members 86A to 86C hardly give forces to minute unevenness that reticle R itself has, but generate forces so as to support only the self weights of reticle R and reticle holders 72A and 72B.

Operations of piston members 86A to 86C and air chambers 90 and 190 are described below using concrete values.

For example, supposing that the mass of reticle R is 340 (g), a support load F at each of six points of support pins 84A to 84C and piston members 86A to 86C equals 0.34x9.8/6 = 0.5533[N] (F=0.34x9.8/6 = 0.5533[N]).

In this case, supposing that a radius of each of piston members 86A to 86C is 1 (mm), a sectional area A becomes $\pi(\text{mm}^2)$, and therefore, supposing that the inner pressure of air chambers 90 and 190 is P and the outside pressure is $P_0$,

$$(P-P_0) = F/A = 177[\text{KPa}] = 1.74[\text{atm}] \text{ holds.}$$

Here, supposing that the outside pressure $P_0$ is 1[atm] = 101.325[KPa],

$$P = 278[\text{KPa}] = 2.74[\text{atm}] \text{ holds,}$$

and therefore, in order for piston members 86A to 86C to support the self weight of reticle R, the pressure inside air chambers 90 and 190 needs to be set to pressure P described above.

The spring stiffness (spring constant) of pistons members 86A to 86C in this case can be computed as below, supposing that the inner volume of the air chamber is V, the inner volume of the air chamber in an initial state is $V_0$, a ratio of specific heat is $\gamma$, and a movement amount of the piston is Z.

From

$$PV^{\gamma} = C, V = V_0 + AZ, (P-P_0) = F/A,$$

$$F = A(P-P_0) = A(CV^{-\gamma} - P_0) = A\{C(V_0+AZ)^{-\gamma} - P_0\}$$

Accordingly,
from

$$K = \partial F / \partial Z,$$

spring constant K can be expressed as

$$K = -A^2C\gamma(V_0+AZ)^{-\gamma-1} = -A^2\gamma PV^{-1}$$

Here, supposing that area $A = \pi$[mm$^2$], ratio of specific heat $\gamma = 1.5$, inner pressure $P = 278$[KPa], and inner volume V of the air chamber $= 5000$mm$^3$,

$$K = 0.26[N/m] \text{ holds.}$$

More specifically, even if the flatness of reticle R is deviated by 1$\mu$m, the acting force from the piston member changes only by $0.26 \times 10^{-6}$[N], and this means that only an extremely minute force changes (the change is less than 1ppm) relative to the original acting force from the piston member (0.55[N]). In this manner, the mechanism configured by the piston members and the air chambers has a function as a weak spring that prevents a force enough to deform reticle R from acting, with respect to the change in the flatness of the reticle. That is, a self-weight cancelling mechanism is constituted by the piston members and the air chambers.

Referring back to FIG. 2, between reticle fine movement stage 30 and reticle coarse movement stage 28 described previously, three voice coil motors 54a to 54c for horizontal drive are arranged. As shown in FIG. 2, one of voice coil motors 54a to 54c, voice coil motor 54c is arranged on the +X side of reticle fine movement stage 30, and the other two voice coil motors, voice coil motors 54a and 54b are arranged on the +Y side of reticle fine movement stage 30.

Each of voice coil motors 54a to 54c has a stator composed of an armature unit having a T shape in a side view that is fixed on the reticle coarse movement stage 28 side, and a mover composed of a magnetic pole unit that is fixed on the reticle fine movement stage 30 side and is finely driven with respect to the stator in a direction indicated by two-headed arrows in FIG. 2. More specifically, reticle fine movement stage 30 is finely driven in the X-axis direction with respect to reticle coarse movement stage 28 by voice coil motor 54c, and is also finely driven in the Y-axis direction and the θz direction with respect to reticle coarse movement stage 28 by voice coil motors 54a and 54b.

Incidentally, in FIG. 1, linear motors LMa and LMb and voice coil motors 54a to 54c that drive reticle stage RST are included and shown as reticle stage drive system 34.

An interferometer beam from an X-axis interferometer 16X is irradiated toward the reflection surface of an X-axis movable mirror 15X on reticle fine movement stage 30, and X-axis interferometer 16X measures relative displacement with respect to the reference surface by receiving a reflected light of the interferometer beam, thereby measuring the position of reticle fine movement stage 30 in the X-axis direction.

Meanwhile, interferometer beams from a pair of double-pass interferometers (hereinafter, referred to Y-axis interferometers) 16Y1 and 16Y2 are irradiated toward the reflection surfaces of a pair of Y-axis movable mirrors 15Y1 and 15Y2 on reticle fine movement stage 30. The respective interferometer beams are irradiated to reflection surfaces 121a and 121b arranged on reticle stage platform 116, via Y-axis movable mirrors 15Y1 and 15Y2, reflected lights of the respective beams reflected off reflection surfaces 121a and 121a return the same optical paths, and are received by the respective Y-axis interferometers, thereby the relative positions in the Y-axis direction of Y-axis movable mirrors 15Y1 and 15Y2 from the reference position are measured respectively. Further, based on the respective measurement results of Y-axis interferometers 16Y1 and 16Y2, a yawing amount (θz rotational amount) of reticle fine movement stage 30 can be measured.

The measurement values of each of interferometers 16X, 16Y1 and 16Y2 are supplied to main controller 20, and linear motors LMa and LMb and voice coil motors 54a to 54c descried earlier are controlled by main controller 20, and accordingly control of the position and attitude of reticle fine movement stage 30 in directions of three degrees of freedom is performed. Incidentally, in FIG. 1, interferometer 16Y2 and movable mirror 15Y2 are representatively shown.

Incidentally, in the embodiment, a reaction force acts on stators 122a and 122b of linear motors LMa and LMb due to movement of reticle stage RST along the Y-axis, and a structure, which includes stators 122a and 122b of linear motors LMa and LMb, counter mass 120, and guides 124a and 124b, moves in a direction opposite to the movement of reticle stage RST.

According to exposure apparatus 100 of the embodiment having the configuration as described above, similar to the conventional scanning stepper, after predetermined preparatory operations such as reticle alignment, baseline measurement of alignment system AS, and wafer alignment by the EGA (Enhanced Global Alignment) method are performed, an exposure operation by a step-and-scan method to wafer W is performed based on results of the wafer alignment and the like. This exposure by a step-and-scan method is performed by repeating an inter-shot movement operation in which wafer stage WST is moved to a scanning starting position (acceleration starting position) for exposure of each shot area on wafer W, and a scanning exposure operation described earlier in which a pattern of reticle R is transferred to each shot area. Incidentally, in the embodiment, various aberrations (a kind of optical characteristics) such as distortion are to be adjusted by movement control of the lens elements by main controller 20 via image-forming characteristic correction controller 251, as needed.

As is described in detail above, according to the embodiment, because reticle R is supported at its +X and -X end portions by flexible reticle holders 72A and 72B, even if there is unevenness on the supported portions of the reticle, reticle holders 72A and 72B are transformed according to the unevenness, and therefore deformation of the reticle accompanying the support by reticle holders 72A and 72B can be restrained as much as possible. Further, by support pins 84A to 84C that contact with reticle holders 72A and 72B at three points that are not disposed in the same straight line, the position setting of reticle holders 72A and 72B in a height direction (the Z-axis direction) at the contacting portions is performed, and also by piston members 86A to 86C (and the air chambers) that contact at three points that are not disposed in the same straight line, occurrence of bending of reticle holders 72A and 72B caused by the self weights of reticle R and reticle holders 72A and 72B can be restrained. Accordingly, occurrence of bending of reticle R due to the self weight can be restrained.

In the embodiment, piston member 86A, support pin 84A and piston member 86B are placed along the Y-axis direction, and support pin 84B, piston member 86C and support pin 84C are placed along the Y-axis direction, and accordingly, the respective members are arranged in two columns and three rows, which makes it possible to substantially uniform the sectional shape of reticle R at each position in a direction (the Y-axis direction) parallel to the columns. More specifically, the Y-position dependency of the XZ sectional shape of reticle R can be excluded.

Accordingly, in the exposure apparatus of the embodiment, since the Y-position dependency of the XZ sectional shape of reticle R held on reticle stage RST is excluded, it is not necessary to perform correction of the image-forming characteristics of projection optical system PL at each Y-position of reticle R during exposure. Accordingly, by only performing initial adjustment of the image-forming characteristics of projection optical system PL via image-forming characteristic correction controller 251, pattern transfer with high precision can be realized.

Further, in the embodiment, because each of pistons members 86A to 86C supports the self weight of the reticle in a state of contacting with reticle holders 72A and 72B, piston members 86A to 86C do not have to directly contact with reticle R, which can prevent the reticle from having flaws.

Incidentally, in the embodiment above, the case has been described where reticle R is held by vacuum suction between reticle holder 72A or 72B and reticle R, but the present invention is not limited thereto, and another means such as magnetic attraction can also be used. Further, reticle R is not suctioned or attracted, but can be held on reticle holders 72A and 72B.

Incidentally, in the embodiment above, the support pints were to be placed at three points that are not located in the same straight line, but the present invention is not limited thereto, and reticle holders 72A and 72B are supported at least one point (are confined in respect of the Z-axis direction), and the self weights of the reticle and reticle holders in the section other than the support point can be supported using the self-weight cancelling mechanism including the piston members.

Incidentally, in the embodiment above, although the case has been described where a mechanism that supports the self weights of the reticle and the reticle holders using the pressure of a gas was employed as the self-weight cancelling mechanism in the present invention, the self-weight cancelling mechanism is not limited thereto, and a mechanism that supports the self weights of the reticle and the reticle holders using a magnetic force can be employed.

Incidentally, in the embodiment above, the case has been described where the support pins and the piston members were disposed in two columns and three rows, but the numbers of columns and rows are not limited thereto, and for example, the arrangement having two columns and four rows can be employed, and the number of rows can be more than four.

Incidentally, in the embodiment above, the case has been described where a total of six support pins and piston members were used, but the total number is not limited to six, and five support pins and piston members in total can also be employed. In this case, the placement in which two are included in one column and three are included in the other column is employed, but even in such a case, it also becomes possible to restrain the bending due to the self weights of the reticle and the reticle holders, compared with, for example, the case where the reticle holders are supported at three points.

Incidentally, in the embodiment above, the case has been described where the intervals between the support pins and the piston members next to each other in the same column (next to each other in a direction parallel to the column) are equal intervals, but the present invention is not limited thereto, and the respective intervals can be different.

Incidentally, in the embodiment above, the case has been described where a pair of the reticle holders are provided, but the present invention is not limited to such a configuration, and for example, a reticle holder composed of a frame-shaped member that supports the entire peripheral section of the reticle can be employed. Further, as the reticle holder, not only the tabular member as shown in FIG. 3 but also other members can be employed.

Incidentally, support mechanism main bodies 82A and 82B can be configured as an integral body and air chamber 90 and air chamber 190 can be formed in a communicating state.

Incidentally, in the embodiment above, the case has been described where the present invention is applied to a scanning type exposure apparatus by a step-and-scan method, but the application range of the present invention is not limited thereto as a matter of course. More specifically, the present invention can be applied to a projection exposure apparatus by a step-and-repeat method, and further to an exposure apparatus by a step-and-stitch method, an exposure apparatus by a proximity method, a mirror projection aligner, or the like. In these cases as well, exposure can be performed in a state where deformation of a reticle is restrained, and therefore, high-precision exposure can be realized.

Incidentally, in the exposure apparatus of the embodiment above, illumination light IL is not limited to the ArF excimer laser, but an ultraviolet light such as a KrF excimer laser light (wavelength: 248nm), or a vacuum ultraviolet light such as an $F_2$ laser light (wavelength: 157nm), an $Ar_2$ laser light (wavelength: 126nm) or a $Kr_2$ laser light (wavelength: 146nm), or an emission line such as a g-line (wavelength: 436nm) or an i-line (wavelength: 365nm) from an extra-high pressure mercury lamp can also be used. Further, a harmonic wave of a YAG laser, or as is disclosed in, for example, the pamphlet of International Publication No. 1999/46835 (the corresponding U.S. Patent No. 7,023,610), a harmonic wave, which is obtained by amplifying a single-wavelength laser beam in the infrared or visible range emitted by a DFB semiconductor laser or fiber laser, with a fiber amplifier doped with, for example, erbium (or both erbium and ytteribium), and by converting the wavelength into ultraviolet light using a nonlinear optical crystal, can also be used. Further, the projection optical system is not only a reduction system, but also can be either an equal magnifying system or a magnifying system, and projection optical system PL is not only a dioptric system, but also can be either a catoptric system or a catadioptric system, and in addition, the projected image can be either an inverted image or an upright image.

Further, in the embodiment above, the illumination light of the exposure apparatus is not limited to the light having a wavelength equal to or more than 100nm, and it is needless to say that the light having a wavelength less than 100nm can be used. For example, in recent years, in order to form a pattern equal to or less than 70nm, an EUV exposure apparatus that makes an SOR or a plasma laser as a light source generate an EUV (Extreme Ultraviolet) light in a soft X-ray range (e.g. a wavelength range from 5 to 15 nm), and uses a total reflection reduction optical system designed under the exposure wavelength (e.g. 13.5nm) and the reflective mask has been developed. In this apparatus, the arrangement in which scanning exposure is performed by synchronously scanning a mask and a wafer using a circular arc illumination can be considered, and therefore, the present invention can also be suitably applied to such an exposure apparatus.

Further, the present invention can also be applied to an exposure apparatus that uses charged particle beams such as an electron beam or an ion beam. Incidentally, an electron beam exposure apparatus can be based on either of a pencil beam method, a variable shaped beam method, a cell projection method, a blanking aperture array method, and a mask projection method.

Further, in the embodiment above, a light-transmitting type mask (reticle), which is a light-transmitting substrate on which a predetermined light shielding pattern (or a phase pattern or a light attenuation pattern) is formed, is used. Instead of this reticle, however, as is disclosed in, for example, U.S. Patent No. 6,778,257, an electron mask (a variable shaped mask) on which a transmissive pattern, a reflection pattern, or an emission pattern is formed according to electronic data of the pattern that is to be exposed can also be used. In the case when such a variable shaped mask is used, in view of detection results of the alignment marks described previously, relative position control of a wafer and a pattern image can be performed by varying a transmissive pattern or a reflection pattern that is to be formed based on the electronic data, when performing exposure of at least one shot area to which exposure will be performed after another shot area that was exposed at the time of detecting the alignment marks, among a plurality of shot areas on a wafer.

Incidentally, the present invention can also be applied to a liquid immersion exposure apparatus disclosed in the pamphlet of International Publication No. 2004/53955. Further, the present invention can also be applied to an exposure apparatus that synthesizes two reticle patterns on a wafer via a double-head type projection optical system and almost simultaneously performs double exposure of one shot area on the wafer by one scanning exposure, as is disclosed in, for example, Kohyo (published Japanese translation of International Publication for Patent Application) No. 2004-519850 (the corresponding U.S. Patent No. 6,611,316).

The use of the exposure apparatus is not limited to the exposure apparatus for manufacturing semiconductor devices, but the present invention can also be widely applied, for example, to an exposure apparatus for liquid crystal display devices that transfers a liquid crystal display device pattern onto a rectangular glass plate, or an exposure apparatus for manufacturing organic ELs, thin-film magnetic heads, imaging devices (such as CCDs), micromachines, DNA chips, or the like. Further, the present invention can be applied not only to an exposure apparatus for producing microdevices such as semiconductor devices, but can also be applied to an exposure apparatus that transfers a circuit pattern onto a glass substrate or silicon wafer to produce a reticle or a mask used in a light exposure apparatus, an EUV exposure apparatus, an X-ray exposure apparatus, an electron-beam exposure apparatus, and the like.

Incidentally, the above disclosures of all the publications, the pamphlets of the International Publications, and the descriptions of the U.S. Patent Application Publication and the U.S. Patents that are cited in the embodiment described above and related to exposure apparatuses and the like are each incorporated herein by reference.

Incidentally, semiconductor devices are manufactured through the following steps: a step where the function/ performance design of a device is performed; a step where a reticle is manufactured based on the design step; a step where a wafer is manufactured using silicon materials; a lithography step where a pattern formed on the mask is transferred onto the photosensitive object by the exposure apparatus of the embodiment above; a device assembly step (including a dicing process, a bonding process, and a packaging process); an inspection step; and the like. In this case, since the exposure apparatus of the embodiment above is used in the lithography step, productivity of the devices with high integration can be improved.

As is described above, the holding device of the present invention is suitable for holding a roughly-tabular -shaped object. Further, the exposure apparatus of the present invention is suitable for transferring a pattern formed on a mask onto a substrate.

## Claims

1. A holding device that holds a roughly-tabular-shaped object, the device comprising:

    a table;
    a contacting member arranged on the table;
    a flexible support member which is arranged on the table in a state where its movement within a horizontal plane is confined, and also a position of which in a height direction at its contacting portion with the contacting member is set by the contacting member that contacts from below, and which supports the object by supporting at least a part of a peripheral section of the object from below; and
    a self-weight cancelling mechanism that contacts with the support member from below and supports self weights of the object and the support member at its contacting portion.

2. The holding device according to Claim 1, further comprising:

    a suction mechanism that holds the object by suction on the support member.

3. The holding device according to one of Claims 1 and 2, wherein
    three of the contacting members are provided, and the three contacting members contact with the support member from below at three points that are not in a same straight line.

4. The holding device according to Claim 3, wherein
    m (m is an odd number not less than three) of the self-weight cancelling mechanisms are provided, and the m self-weight cancelling mechanisms contact with the support member from below at m points that are not in a same straight line.

5. The holding device according to Claim 4, wherein
    each of the self-weight cancelling mechanisms supports the self weights of the object and the support member using a pressure of a gas.

6. The holding device according to one of Claims 4 and 5, wherein
    the (three + m) points, which is a total of the three points at which the contacting members contact with the support member from below and the m points at which the self-weight cancelling mechanisms contact with the support member from below, are arranged in two columns and n rows (n is a natural number not less than three).

7. The holding device according to Claim 6, wherein
    intervals between the contacting points next to each other in a same column are set to equal intervals.

8. The holding device according to one of Claims 6 and 7, wherein
    the support member has a pair of support plates that respectively support one end and the other end of the object in a direction parallel to the rows of the contacting points, and
    the contacting points making up one of the two columns are located on a lower surface of one of the pair of support plates, and the contacting points making up the other of the two columns are located on a lower surface of the other of the pair of support plates.

9. A holding device that holds a roughly-tabular-shaped object, the device comprising:

    a table;
    three first contacting members arranged on the table;

a flexible support member which is arranged on the table in a state where its movement within a horizontal plane is confined, and also which is supported by the three first contacting members that contact from below at three first contacting points that are not in a same straight line, a position of which in a height direction at each of the first contacting points is set by the three first contacting members, and which supports the object by supporting at least a part of a peripheral section of the object from below; and

m (m is an odd number not less than three) second contacting members that contact with the support member from below at m second contacting points that are not in a same straight line, wherein

the three first contacting points and the m second contacting points are arranged in two columns and n rows (n is a natural number not less than three).

10. The holding device according to Claim 9, further comprising:

a suction mechanism that holds the object by suction on the support member.

11. The holding device according to one of Claims 9 and 10, wherein
each of the second contacting members constitutes a part of a self-weight cancelling mechanism that supports self weights of the object and the support member using a pressure of a gas.

12. The holding device according to any one of Claims 9 to 11, wherein
the support member has a pair of support plates that respectively support one end and the other end of the object in a direction parallel to the rows of the contacting points, and
the contacting points making up one of the two columns are located on a lower surface of one of the pair of support plates, and the contacting points making up the other of the two columns are located on a lower surface of the other of the pair of support plates.

13. The holding device according to any one of Claims 9 to 12, wherein
intervals between the contacting points next to each other in a same column are set to equal intervals.

14. An exposure apparatus that transfers a pattern formed on a mask onto a substrate, the apparatus comprising:

the holding device according to any one of Claims 1 to 13 that supports the mask as the object.

15. An exposure apparatus that transfers a pattern formed on a mask onto a substrate, the apparatus comprising:

the holding device according to any one of Claims 6 to 13 that supports the mask as the object; and
a synchronous movement device that synchronously moves the mask and the substrate in a direction parallel to the columns.

*Fig. 1*

Fig. 2

*Fig. 3*

*Fig. 4A*

*Fig. 4B*

*Fig. 5*

**INTERNATIONAL SEARCH REPORT**

| | International application No. |
|---|---|
| | PCT/JP2007/060243 |

A.  CLASSIFICATION OF SUBJECT MATTER
*H01L21/027*(2006.01)i, *H01L21/683*(2006.01)i

According to International Patent Classification (IPC) or to both national classification and IPC

B.  FIELDS SEARCHED

Minimum documentation searched (classification system followed by classification symbols)
H01L21/027, H01L21/683

Documentation searched other than minimum documentation to the extent that such documents are included in the fields searched
Jitsuyo Shinan Koho        1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X | JP 2001-196303 A  (ASM LITHOGRAPHY BV), 19 July, 2001 (19.07.01), Full text; all drawings (particularly, Par. Nos. [0035] to [0038]; Figs. 5, 6) & EP 1107066 A2        & US 6480260 B1 | 1-15 |
| X | JP 2006-041302 A  (Canon Inc.), 09 February, 2006 (09.02.06), Full text; all drawings (particularly, Figs. 5 to 9) (Family: none) | 1-3,14 |
| X | JP 62-079647 A  (Hitachi, Ltd.), 13 April, 1987 (13.04.87), Full text; all drawings (particularly, Fig. 4(b)) & US 4666291 A | 1-5 |

☒ Further documents are listed in the continuation of Box C.       ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 01 June, 2007 (01.06.07) | 12 June, 2007 (12.06.07) |

| Name and mailing address of the ISA/ Japanese Patent Office | Authorized officer |
|---|---|
| Facsimile No. | Telephone No. |

Form PCT/ISA/210 (second sheet) (April 2005)

| INTERNATIONAL SEARCH REPORT | International application No. |
|---|---|
| | PCT/JP2007/060243 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2005-235890 A  (Canon Inc.), 02 September, 2005 (02.09.05), Full text; all drawings & US 2005/185166 A1 | 1,9 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001196303 A
- JP 2001313250 A
- US 20030025890 A
- JP 9219354 A
- JP 6283403 A
- US 5448332 A
- JP 7176468 A

- US 5646413 A
- US 199946835 B
- US 7023610 B
- US 6778257 B
- US 200453955 B
- JP 2004519850 A
- US 6611316 B